# EUROPEAN PATENT APPLICATION

(11) **EP 0 794 569 A2**
(43) Date of publication of application: **10.09.1997**
(21) Application number: 97103713.0
(22) Date of filing: 06.03.1997
(51) Int. Cl.: H01L 21/768, H01L 21/314, C23C 16/26

(54) **Amorphous carbon film, formation process thereof, and semiconductor device making use of the film**

(30) Priority: 07.03.1996 JP 49764/96
(71) Applicant: NEC CORPORATION, Tokyo (JP)
(72) Inventor: Endo, Kazuhiko, Minato-ku, Tokyo (JP); Tatsumi, Toru, Minato-ku, Tokyo (JP)
(74) Representative: Betten & Resch

(57) **Abstract**

This invention relates to a fluorine-containing amorphous carbon film with benzene rings distributed therein. The film is formed by plasma CVD while using an aromatic hydrocarbon gas and a fluoride gas as raw materials. This invention is also concerned with a semiconductor layer which features use of the fluorine-containing amorphous carbon film as an interlayer insulating film. The fluorine-containing amorphous carbon film has a low specific dielectric constant, does not contain much intrafilm water and is superior in heat resistance, so that the fluorine-containing amorphous carbon film permits application of a known conductive-pattern-forming process, which requires heat treatment at elevated temperature, and can provide a semiconductor device with reduced signal delays.

## Description

### BACKGROUND OF THE INVENTION

### 1. Field of the Invention

This invention relates to an insulating material useful as a conductive pattern in a semiconductor device, and especially to an amorphous carbon film which, as an insulating material, has a low specific dielectric constant and can reduce interconnecting delays compared with conventional semiconductor devices. This invention is also concerned with a process for the formation of the amorphous carbon film and also with a semiconductor device making use of the amorphous carbon film.

### 2. Description of the Related Art

Reflecting the recent move toward semiconductor devices with reduced conductor width and spacing, the semiconductors tend to be increased in stray capacity and conductor resistance. Keeping in step with this tendency, the interconnecting delay time is expected to increase further, thereby possibly causing problems in the high-speed operation of semiconductor devices. Accordingly, with a view to reducing interconnecting delays, another look is being given to insulating film materials for multilayer interconnection structures.

In general, an interconnecting delay is proportional to the square root of the specific dielectric constant of an insulating film material. It is therefore possible to reduce the interconnecting delay by using, as the insulating film material, one having a low specific dielectric constant.

As interlayer insulating film materials, those having a specific dielectric constant of about 4 or so, for example, SiO₂ and the like have been used to date. Also employed are SiOF films with a specific dielectric constant reduced to 3.5 or so owing to the inclusion of fluorine in SiO₂. It is however desired to reduce the specific dielectric constant further to 3 or lower in view of the future trend toward semiconductor devices having still reduced conductor width and spacing.

Organic materials, such as polyimides which have a dielectric constant lower than inorganic materials such as SiO₂ and have a specific dielectric constant of about 3 or so, have hence been proposed and studied.

To apply an organic material such as a polyimide as an interlayer insulating film in a semiconductor device, it is necessary to deposit such an organic material as a thin uniform layer on a substrate. For a conventional organic material such as a polyimide, a coat polymerization process is employed, that is, a coating formulation of a precursor such as a solution of polyamic acid is uniformly applied on a substrate, followed by a polymerization of the precursor under heat. In this case, the uniform application of the coating formulation of the precursor requires to prepare the coating formulation with a reduced viscosity. To this end, a solvent is used in an increased amount. As a corollary of this, it has heretofore been needed to overcoat the coating formulation many times so that a thick film is formed.

Although an organic material such as a polyimide has a specific dielectric constant as low as about 3, it is accompanied by a problem that, because of the formation of a film by a coating process, many steps have to be carried out for the formation of a uniform thick film on a substrate. Such an organic material also involves a potential problem that, when a wet process such as a coating process is used upon using a polyimide resin as an interlayer insulating film, there is a possibility that water may be trapped in the film. This intrafilm water may give adverse effects on a semiconductor element to be formed, or lead to cracks or the like due to volume shrinkage upon hardening.

An another process for forming such an interlayer insulating film, a plasma polymerization process is known. In this process, a molecular raw material is introduced as a gas into a vacuum, a plasma is produced to activate the molecules, and the molecules are polymerized on a substrate. According to this plasma polymerization process, a film can be evenly formed on the substrate by making uniform the in-plane distribution of active species in a plasma, and the thickness of the film can be easily controlled.

When a film is formed by this plasma polymerization process while using benzene or toluene as a feed gas, the film can be uniformly formed on a substrate and its thickness can be readily controlled. Its specific dielectric constant is however still as high as approximately 3 to 3.5, which is insufficient to meet still further reductions in the conductor width and spacing of semiconductor devices.

In the meantime, one of the present inventors proposed in Japanese Patent Laid-Open No. 83842/1996, as an insulating film capable of achieving a specific dielectric constant of 3 or lower, a fluorine-containing amorphous carbon film which can be formed by forming an aliphatic hydrocarbon gas such as methane and a fluorine-containing gas such as CF₄ into a plasma and reacting the thus-formed reactive species such as radical molecules and ions on a substrate.

The fluorine-containing amorphous carbon film formed by the above process can achieve a specific dielectric constant as low as 3 or even lower, and has excellent properties such that, as no water is produced upon formation of the film, the film does not contain any intrafilm water and protects a device from adverse effects which would otherwise be given to the device. Even with this film, however, a still further improvement is desired concerning its heat resistance upon formation of a conductive pattern.

### SUMMARY OF THE INVENTION

With a view to overcoming the above-described problems, an object of the present invention is to provide an interlayer insulating film having a specific dielectric constant of 3 or lower, does not contain much intrafilm water and is excellent in heat resistance.

Another object of the present invention is to provide a process for the formation of the interlayer insulating film.

A still further object of the present invention is to provide a semiconductor device which makes use of the interlayer insulating film and is reduced in interconnecting delay.

The present inventors have proceeded with an extensive investigation to achieve these objects. As a result, they have found that the above objects can be attained by using a fluorine-containing amorphous carbon film, which contains benzene rings, as an interlayer insulating film, leading to the completion of the present invention.

Namely, the present invention provides a fluorine-containing amorphous carbon film, which comprises a fluorine-containing amorphous carbon with benzene rings distributed therein.

The present invention also provides a process for the formation of the fluorine-containing amorphous carbon film, which comprises depositing the film on a substrate by plasma CVD while using an aromatic hydrocarbon gas and a fluoride gas as raw materials.

Further, the present invention provides a semiconductor device, which comprises, as an interlayer insulating film, the above fluorine-containing amorphous carbon film.

Owing to the inclusion of benzene rings in fluorine-containing amorphous carbon, the present invention can provide a fluorine-containing amorphous carbon film which has heat resistance improved to as high as 450°C or so and a specific dielectric constant as low as 3 or even lower, contains intrafilm water only at an extremely low level, and is excellent as an interlayer insulating film for a semiconductor device. In particular, use of the fluorine-containing amorphous carbon film of this invention as an interlayer insulating film in a multilayer interconnection structure of a semiconductor device makes it possible to reduce interconnecting delays owing to its low specific dielectric constant and moreover, makes it possible to fabricate the semiconductor device by a conventional conductive pattern-forming process which requires heating to 400°C or so, thereby bringing about another advantage from the standpoint of fabrication cost.

### BRIEF DESCRIPTION OF THE DRAWINGS

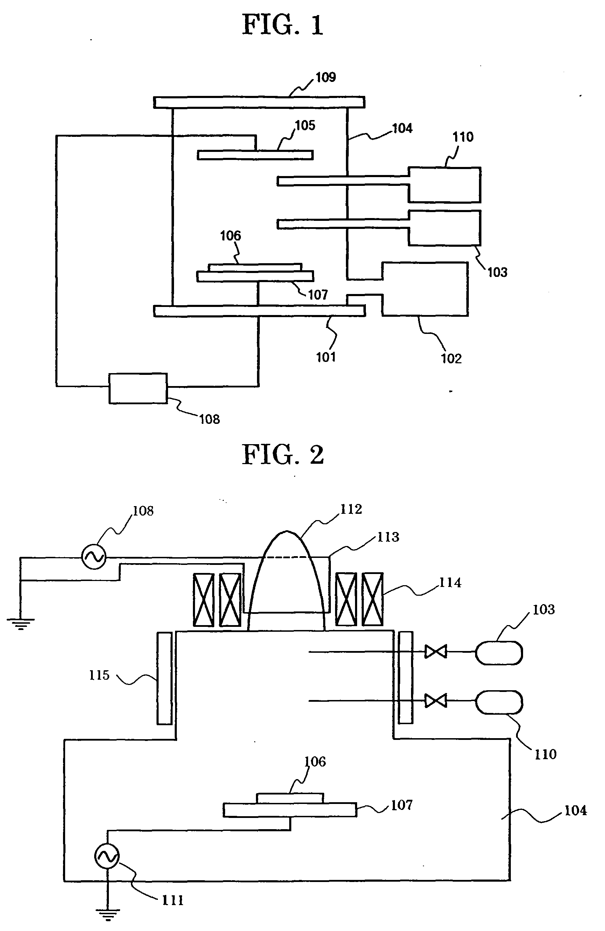

FIGS. 1 and 2 are simplified schematic diagrams showing the constructions of deposition systems for forming a fluorine-containing amorphous carbon film with benzene rings distributed therein according to the present invention, in which FIG. 1 illustrates a parallel-plate plasma chemical vapor deposition (CVD) system and FIG. 2 depicts a helicone-wave-excited CVD system; and

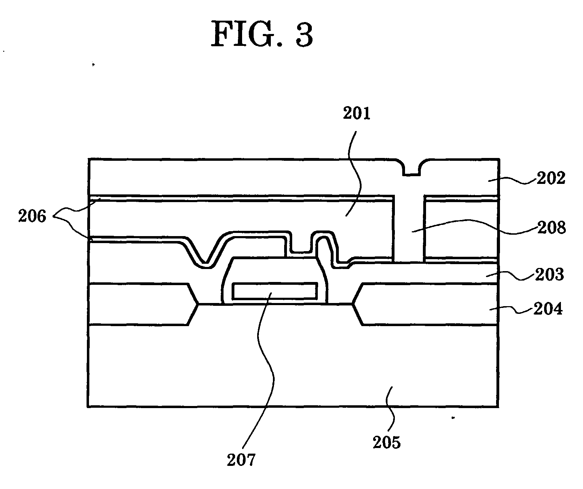

FIG. 3 is a simplified transverse schematic view of a semiconductor device making use of fluorine-containing amorphous carbon films with benzene rings distributed therein according to the present invention as interlayer insulating films.

### DETAILED DESCRIPTION OF THE PREFERRED EMBODIMENTS

The present invention will hereinafter be described in detail.

The fluorine-containing amorphous carbon film with benzene rings distributed therein, which pertains to the present invention, is provided with improved heat resistance without an increase in the specific dielectric constant of the whole fluorine-containing amorphous carbon film owing to the inclusion of the benzene rings, which has high heat resistance for their cyclic, relatively strong carbon bridge structure, in the fluorine-containing amorphous carbon inherently having a low specific dielectric constant.

To form the fluorine-containing amorphous carbon film with benzene rings distributed therein, a plasma CVD process is conducted using an aromatic hydrocarbon gas and a fluoride gas as feed gases.

Usable examples of the aromatic hydrocarbon gas as the raw material include aromatic hydrocarbons which can be gasified in a plasma CVD system, such as benzene, toluene and xylene. Illustrative of the other raw material, i.e., the fluoride gas are fluorocarbons such as CF₄, C₂F₆, C₄F₈, C₂F₄ and C₂F₂ and fluorides such as SF₆ and NF₃. These feed gases can be used either singly or in combination.

About the plasma CVD process making use of these feed gases, a specific description will hereinafter be made with reference to the drawings of the deposition systems.

The parallel-plate plasma CVD system of FIG. 1 will be described first. This system comprises a vacuum chamber 104 defined between a base 101 and an upper cover 109, and an upper electrode 105 and a substrate holder 107, which also serves as a lower electrode, both arranged in the vacuum chamber 104. The system further comprises a power supply 108 to apply D.C. or A.C. electric power across the upper electrode 105 and the substrate holder 107. The substrate holder 107 is provided with an unillustrated specimen heater so that a specimen placed on the substrate holder 107 can be heated to a desired temperature. Feed gases are introduced into the vacuum chamber 104 from a fluoride-gas-feeding cylinder 103 and an aromatic-hydrocarbon-gas-feeding cylinder 110, respectively. The interior of the vacuum chamber 104 can be controlled to a desired pressure by a vacuum pump 102.

A description will next be made of a depositing operation making use of the system. The specimen 106 such as a silicon substrate or the like is placed on the substrate holder 107. After the interior of the vacuum chamber 104 is once depressurized to a predetermined vacuum level by the vacuum pump 102, an aromatic hydrocarbon gas such as benzene, toluene or xylene is introduced from the gas cylinder 110 and at a vacuum level of from 0.01 to 0.5 Torr, R.F. or D.C. electric power is applied across the electrodes to produce a discharge so that a hydrocarbon plasma is produced. For example, when R.F. electric power is applied between the upper electrode 105 and the substrate holder 107 from the power supply 108, a bias voltage of about several hundreds volts is impressed to the substrate holder 107. Ions accelerated under the bias voltage are irradiated onto the specimen 106 on the substrate holder 107, whereby a crosslinked amorphous carbon film is formed on the specimen 106. At this time, a fluoride gas is concurrently introduced from the gas cylinder 103 and is excited by the plasma, whereby fluorine is included in the amorphous carbon film.

When an Si or SiO₂ substrate is used as the specimen 106, a problem arises that the resulting fluorine-containing amorphous carbon film, which contains benzene rings, is susceptible to delamination because of low adhesion of the film with the substrate. To avoid this problem, the adhesion can be improved by first depositing on the specimen a fluorine-free, hydrogenated amorphous carbon film from an aliphatic hydrocarbon gas such as CH₄ and then performing deposition of a fluorine-containing amorphous carbon film which contains benzene rings.

Next, a description will be made about the helicone-wave-excited plasma CVD system shown in FIG. 2. In this system, an antenna 113 is wound on and around a silica cylinder 112. Surrounding this antenna, a coil 114 is arranged to form an external magnetic field. By applying an R.F. voltage across the antenna from an R.F. power supply 108, a helicone wave is produced. At this time, feed gases are introduced into a vacuum chamber 104 from feed gas cylinders 103,110, respectively, so that a plasma is produced in a region surrounded by a permanent magnet 115. On the other hand, a specimen 106 is placed on a substrate holder 107 which is electrically connected to a bias power supply 111. By applying a bias voltage, a film is formed on a surface of the specimen 106. Incidentally, the interior of the vacuum chamber 104 is controlled at a predetermined vacuum level by unillustrated exhaust means.

In addition to the above-described R.F. discharge or D.C. discharge, it is also possible to use a discharge such as a microwave discharge, a magnetron-induced discharge, or an inductive coupled discharge which is produced by a coil.

The present invention will hereinafter be described by specific Examples. It is however to be borne in mind that the present invention is by no means limited to these Examples.

### Example 1

Using the system of FIG. 1, CH₄ was introduced as a feed gas at a flow rate of 10 sccm into the vacuum chamber and a plasma was produced with electric power of 200 W under a pressure of 0.1 Torr for 10 minutes, so that a hydrogenated amorphous carbon film was deposited to a thickness of about 30 nm on an Si substrate.

Next, CF₄ gas and toluene were used as feed gases. CF₄ and toluene were each introduced at a flow rate of 5 sccm into the vacuum chamber and a plasma was produced with electric power of 200 W under a pressure of 0.1 Torr for about 2 to 10 minutes, whereby a fluorine-containing amorphous carbon film with benzene rings distributed therein was deposited to a thickness of about 1 µm on the hydrogenated amorphous carbon film. At this time, delamination or the like was not observed.

When CF₄ was used as a fluoride as described above, the fluorine/carbon content ratio in the film was 1.2 and the specific dielectric constant of the film was 2.2. The specific dielectric constant was confirmed to vary depending on the content of fluorine in the film. Described specifically, use of C₂F₆ instead of CF₄ under the same conditions as described above resulted in a fluorine/carbon content ratio of 1.1 and a specific dielectric constant of 2.3, whereas use of C₄F₈ led to a fluorine/carbon content ratio of 1.0 and a specific dielectric constant of 2.4. There is accordingly the tendency that the specific dielectric constant becomes greater as the fluorine/carbon content ratio becomes smaller.

The film deposited in this Example was analyzed by infrared absorption spectrophotometry. As a result, a peak derived form C-F bonds was observed along with peaks attributable to benzene rings and C-H bonds, respectively. It is therefore understood that the deposited film formed in this Example is an amorphous carbon film which contains both benzene rings and fluorine atoms.

### Examples 2-6 and Comparative Example 1

Next, various films were formed by parallel-plate plasma CVD in the same manner as in Example 1 except that the combination of the feed gases was changed in various ways as shown in Table 1. The decomposition-starting temperatures of those films were determined as indices of their heat resistance. The results are presented in Table 1. In addition, the results of an example in which no benzene-ring-containing compound was used as a feed gas are also presented as Comparative Example 1 in the same table.

**Table 1**

| | Feed gas | Decomposition starting temperature | Specific dielectric constant |
|---|---|---|---|
| Comp. Ex. 1 | CH₄ + CF₄ | 280°C | 2.1 |
| Example 1 | CF₄ + toluene | 350°C | 2.2 |
| Example 2 | C₂F₆ + toluene | 400°C | 2.3 |
| Example 3 | C₄F₈ + toluene | 450°C | 2.4 |
| Example 4 | CF₄ + xylene | 350°C | 2.2 |
| Example 5 | C₂F₆ + xylene | 400°C | 2.3 |
| Example 6 | C₄F₈ + xylene | 450°C | 2.4 |

From Table 1, it is understood that the decomposition-starting temperatures of the amorphous carbon films deposited using the benzene-ring-containing compound such as toluene are higher than that of the fluorine-containing amorphous carbon film deposited without using such a benzene-ring-containing compound (Comparative Example 1). It has therefore been ascertained that use of a compound containing a benzene ring in a part of its molecular structure as a feed gas for deposition can provide an amorphous carbon film having a specific dielectric constant lower than 3 and improved heat resistance.

The above examples were all conducted using the parallel-plate plasma CVD system. A description will next be made of examples in each of which deposition was conducted using the helicone-wave-excited CVD system of FIG. 2.

### Example 7

Using the system of FIG. 2, CH₄ was introduced as a feed gas at a flow rate of 100 sccm into the vacuum chamber and a plasma was produced under a pressure of 1 mTorr with electric power of 2 kW for 10 seconds, so that a hydrogenated amorphous carbon film was deposited to a thickness of about 30 nm on an Si substrate.

Next, CF₄ gas and toluene were used as feed gases. CF₄ and toluene were each introduced at a flow rate of 50 sccm into the vacuum chamber and a plasma was produced with electric power of 2 kW under a pressure of 1 mTorr for about 2 minutes, whereby a fluorine-containing amorphous carbon film with benzene rings distributed therein was deposited to a thickness of about 1 µm on the hydrogenated amorphous carbon film. At this time, delamination or the like was not observed.

When CF₄ was used as a fluoride as described above, the fluorine/carbon content ratio in the film was 1.2 and the specific dielectric constant of the film was 2.2. The specific dielectric constant was confirmed to vary depending on the content of fluorine in the film. Described specifically, use of C₂F₆ instead of CF₄ under the same conditions as described above resulted in a fluorine/carbon content ratio of 1.1 and a specific dielectric constant of 2.3, whereas use of C₄F₈ led to a fluorine/carbon content ratio of 1.0 and a specific dielectric constant of 2.4. There is accordingly the tendency that the specific dielectric constant becomes greater as the fluorine/carbon content ratio becomes smaller.

The film deposited in this Example was analyzed by infrared absorption spectrophotometry. As a result, a peak derived form C-F bonds was observed along with peaks attributable to benzene rings and C-H bonds, respectively. It is therefore understood that the deposited film formed using the deposition system of FIG. 2 is also an amorphous carbon film which contains both benzene rings and fluorine atoms.

### Examples 8-12 and Comparative Example 2

Next, various films were formed by helicone-wave-excited plasma CVD in the same manner as in Example 7 except that the combination of the feed gases was changed in various ways as shown in Table 2. The decomposition-starting temperatures of those films were determined as indices of their heat resistance. The results are presented in Table 2. In addition, the results of an example in which no benzene-ring-containing compound was used as a feed gas are also presented as Comparative Example 2 in the same table.

**Table 2**

| | Feed gas | Decomposition starting temperature | Specific dielectric constant |
|---|---|---|---|
| Comp. Ex. 2 | CH₄ + CF₄ | 300°C | 2.3 |
| Example 7 | CF₄ + toluene | 380°C | 2.2 |
| Example 8 | C₂F₆ + toluene | 430°C | 2.3 |
| Example 9 | C₄F₈ + toluene | 450°C | 2.4 |
| Example 10 | CF₄ + xylene | 380°C | 2.2 |
| Example 11 | C₂F₆ + xylene | 430°C | 2.3 |
| Example 12 | C₄F₈ + xylene | 450°C | 2.4 |

From Table 2, it is understood that the decomposition-starting temperatures of the amorphous carbon films deposited using the benzene-ring-containing compound such as toluene are higher than that of the fluorine-containing amorphous carbon film deposited without using such a benzene-ring-containing compound (Comparative Example 2). It has therefore been ascertained that use of a compound containing a benzene ring in a part of its molecular structure as a feed gas for deposition can provide an amorphous carbon film having a specific dielectric constant lower than 3 and improved heat resistance.

As is appreciated from Tables 1 and 2, the use of xylene as an aromatic hydrocarbon to be added also led, like the use of toluene, to improved heat resistance owing to the incorporation of benzene rings in the resultant films. Similar results were also obtained from fluorine-containing amorphous carbon films containing benzene rings, which were deposited likewise by a discharge produced by a magnetron or by a microwave.

Conventional plasma-polymerized films, which are obtained using only an aromatic hydrocarbon such as toluene, are accompanied by the problem that they have hygroscopicity. Further, high molecular films which are formed through a dehydrating condensation reaction of a polyimide or the like involve a problem such that due to intrafilm water, they damage conductive patterns when employed as interlayer insulating films. Based on an investigation on the hygroscopicity of benzene-ring-containing, fluorine-containing amorphous carbon films according to the present invention, it has also been found that they had extremely low hygroscopicity and contained intrafilm water only at very low levels. They have hence been ascertained to give substantially no damages to conductive patterns.

It has also been found that deposition from an aromatic hydrocarbon gas with a fluoride gas such as a fluorocarbon added therein can improve the deposition rate by about two times or so compared with a plasma-polymerized film deposited from the aromatic hydrocarbon gas alone. According to deposition by a plasma, active species formed by the plasma are adsorbed on active sites which exist as unbonded or free hands or the like on a surface of a film, so that deposition takes place. Owing to the addition of the fluoride gas, the active species of fluorine atoms activated by the plasma are considered to eliminate hydrogen atoms which exists on the surface of the plasma-polymerized film, leading to an increase in the density of active sites on the surface. This increase is considered to have led to the improved deposition rate.

### Example 13

Reference is next had to FIG. 3. The semiconductor device shown in FIG. 3 was fabricated using, as interlayer insulating films, fluorine-containing amorphous carbon films which contained benzene rings and formed as described above. The fabrication of the semiconductor device will be described hereinafter.

First, an SiO₂ layer and a transistor 207 are formed on a silicon substrate 205 or the like by a usual technique. Subsequent to deposition of an electrode material 203 such as aluminum, the electrode material 203 is formed into a conductive pattern by a lithographic technique known to the public.

The silicon substrate with the conductive pattern 203 formed thereon is next placed in the parallel-plate plasma CVD system of FIG. 1 or the helicone-wave-excited plasma CVD system of FIG. 2. As in the corresponding Example described above, CH₄, CF₄ gas and toluene are introduced into the plasma system so that a plasma is produced to deposit an amorphous carbon film. Described specifically, in the case of the parallel-plate plasma CVD system, CH₄ was introduced as a feed gas at a flow rate of 10 sccm into the vacuum chamber and a plasma was produced with electric power of 200 W under a pressure of 0.1 Torr for 10 minutes, so that a hydrogenated amorphous carbon film 206 was deposited to a thickness of about 30 nm on the conductive pattern 203.

Next, CF₄ gas and toluene were used as feed gases. CF₄ and toluene were each introduced at a flow rate of 5 sccm into the vacuum chamber and a plasma was produced with electric power of 200 W under a pressure of 0.1 Torr for about 2 to 10 minutes, whereby a fluorine-containing amorphous carbon film 201 with benzene rings distributed therein was deposited to a thickness of about 1 µm on the hydrogenated amorphous carbon film.

Similarly, in the case of the helicone-wave-excited plasma CVD system, a hydrogenated amorphous carbon film was deposited to a thickness of about 30 nm by using CH₄ and a fluorine-containing amorphous carbon film 201 with benzene rings distributed therein was deposited to a thickness of about 1 µm on the hydrogenated amorphous carbon film by using CF₄ and toluene.

The amorphous carbon film 201 formed as described above was next patterned into a desired shape. On the amorphous carbon film 201, a hydrogenated amorphous carbon film 206 of about 30 nm in thickness was first formed as a buffer layer in a similar manner as described above. SiO₂ was then deposited to a thickness of about 300 nm. This SiO₂ layer was first patterned by the conventional microprocessing technique. Using the thus-patterned SiO₂ layer as a mask, the amorphous carbon films 206,201 were then etched to form a via hole 208. Using oxygen gas as an etching gas, this etching was conducted in a reactive ion etching (RIE) system.

After the etching, the SiO₂ layer which had been used as the mask was removed with hydrofluoric acid, and aluminum was deposited by a sputtering method in the via hole 208 formed in the amorphous carbon film 206 and also on the amorphous carbon film 206 so that the conductive pattern 202 as the second layer and the conductive pattern 203 as the first layer were electrically connected.

When the fluorine-containing amorphous carbon film 201, which contains benzene rings, is in direct contact with Si, SiO₂ or the like, the adhesion of the film is weak so that the film is prone to delamination. The hydrogenated amorphous carbon film 206 is formed to avoid such delamination.

The use of the fluorine-containing amorphous carbon film, which contains benzene rings and pertains to the present invention, as an interlayer insulating film has made it possible to apply a conventionally-known conductive-pattern-forming process which requires heat treatments at elevated temperatures in the deposition of a metallic conductor material and its subsequent heat treatment. In this Example, heat treatment was conducted at 400°C subsequent to the deposition step of the metallic conductor material.

An interconnecting delay time of the semiconductor device of this Example was measured. Compared with semiconductor devices making use of SiO₂ as interlayer insulating films, the semiconductor device of this Example succeeded in reducing the interconnecting delay to about 80%.

This effect was also equally available when upon formation of the fluorine-containing amorphous film 201 with benzene rings distributed therein, a fluoride other than the above-described CF₄, such as C₂F₆ or C₄F₈, was used as a raw material, i.e., a fluorine source or xylene was used as an aromatic hydrocarbon in place of toluene.

As has been described above, the use of a fluorine-containing amorphous carbon film with benzene rings distributed therein as an interlayer insulating film has made it possible to fabricate a semiconductor device, which is reduced in interconnecting delays than conventional semiconductor devices, by using the same conductive-pattern-forming process as that employed to date.

## Claims

1. A fluorine-containing amorphous carbon film comprising fluorine-containing amorphous carbon with benzene rings distributed therein.

2. A process for the formation of a fluorine-containing amorphous carbon film with benzene rings distributed therein, which comprises depositing said film on a substrate by plasma CVD while using an aromatic hydrocarbon gas and a fluoride gas as raw materials.

3. A semiconductor device comprising, as an interlayer insulating film, the fluorine-containing amorphous carbon film according to claim 1.

4. The semiconductor device according to claim 3, wherein said fluorine-containing amorphous carbon film is formed over an Si or SiO₂ substrate with a hydrogenated amorphous carbon film formed at an interface between said fluorine-containing amorphous carbon film and said Si or SiO₂ substrate.
